# EUROPEAN PATENT APPLICATION

(11) **EP 4 790 402 A1**
(43) Date of publication of application: **12.08.2026**
(21) Application number: 26152780.8
(22) Date of filing: 20.01.2026
(51) Int. Cl.: G01N 27/414

(54) **BIOSENSOR**

(30) Priority: 10.02.2025 WO PCT/KR2025/001918
(71) Applicant: LG Electronics Inc., Yeongdeungpo-gu Seoul 07336 (KR)
(72) Inventor: KIM, Younghwa, Seoul 07796 (KR)
(74) Representative: Vossius & Partner Patentanwälte Rechtsanwälte mbB

(57) **Abstract**

Proposed is a biosensor. The biosensor includes a substrate, a first gate formed on the substrate, a second gate formed on the substrate, and a potential measurement unit formed between the first gate and the second gate and configured to measure potential of the first gate and potential of the second gate, wherein channel portions are formed between the first gate and the potential measurement unit and between the potential measurement unit and the second gate, so it has an effect that it is possible to reduce measurement noise and improve the sensing accuracy by maintaining gate potential at a constant level.

## Description

### BACKGROUND

### Technical Field

The present disclosure relates to a biosensor and, in more detail, a biosensor that generates an electrical signal by detecting a biological substance.

### Description of the Related Art

As science and technology continue to advance and interest in quality of life grows, the importance of disease diagnosis and prevention, as well as food and environmental safety, continues to increase in human life. As a result, the need for measuring the concentration of organic or inorganic substances in samples has been increasing for diagnosing human diseases, for specific processes in the fields of food chemistry and industrial chemistry, or for analyzing pollutants in the environmental field, and many efforts have been made to meet this need.

A biosensor is a device that measures concentration by combining biological substances such as enzymes, microorganisms, antibodies, receptors, and DNA probes with an electrical or physicochemical transducer, and sensing electroactive substances or physical changes generated from reactions with an analyte through signals using methods such as electrochemical, optical, thermal, or piezoelectric mechanisms.

In general, detection of biological substances using a biosensor is performed through a combination of complex processes such as filtering, metering, mixing, transport, reaction, and washing. Accordingly, in the related art, detection of biological substances is conducted manually at the laboratory level using a variety of equipment.

Accordingly, as biosensor technology advances, simultaneous development of fluid handling technology for automating and standardizing a diagnostic process can be said to be highly important for low-cost and high-efficiency diagnostics.

Among these, the equipment for detecting biological substances needs to clean the flow paths inside the equipment before measuring each biological sample. Further, in order to diagnose multiple samples, a large volume of buffer solution must be stored in a tank, which raises concerns about deterioration, and there is the inconvenience of periodically disposing of a waste solution after diagnosis. When using such equipment, there is a limitation in that the diagnostic speed may decrease when it is required to diagnose a large number of samples, and the accuracy may also be deteriorated.

In order to solve these problems, a disposable biosensor cartridge with internal flow paths for the flow of a buffer solution and a sample solution may be used. Since disposable biosensor cartridges are used only once, a separate cleaning process is unnecessary. Further, since each cartridge is provided with a single-use buffer solution, there is no risk of buffer solution degradation and an advantage is that when a cartridge is discarded, a waste solution is also disposed of.

In this regard, an on-site molecular diagnostic system has been disclosed in Korean Patent Application Publication No. KR 10-2022-0047600A.

The on-site molecular diagnostic system includes a cartridge and a diagnostic device and a biological sample can be accommodated in the cartridge and then inserted into the diagnostic device to undergo various sample processing steps.

The on-site molecular diagnostic system is configured such that the cartridge is inserted into the diagnostic device in an upright position.

Further, when a pneumatic device is provided to induce a buffer solution or a sample solution to flow and a cartridge is inserted, the buffer solution or the sample solution is induced to flow by supplying pneumatic pressure into the cartridge.

However, when the cartridge is inserted in a direction perpendicular to the ground, as described above, a buffer solution or a sample solution may flow due to gravity, so there is a limitation in that precise control may not be possible due to the flow of the buffer solution or the sample solution regardless of the operation of the diagnostic device.

Further, since the diagnostic device needs to be equipped with a pneumatic device with a relatively large volume, the volume of the diagnostic device may be increased, which may cause inconvenience when transporting the diagnostic device to a required diagnostic site or installing it on-site.

Further, since it is difficult to finely control the output of pneumatic devices, it is difficult to control the flow rate and the flow velocity of a buffer solution or a sample solution flowing in the cartridge, so there is a limitation in that accuracy is deteriorated due to errors in diagnostic data.

The biosensors in the related art have the problem that errors occur and sensing accuracy decreases as the gate potential changes due to variations in the state of a fluid.

### SUMMARY

The present disclosure has been made in an effort to solve the problems described above and an objective of the present disclosure is to provide a biosensor that can reduce measurement noise and enhance sensing accuracy by maintaining gate potential at a predetermined level.

Another objective is to provide a biosensor that can enhance sensing accuracy by allowing greater flexibility in fluid movement direction.

In order to achieve the objectives, a biosensor according to the present disclosure includes: a substrate; a first gate formed on the substrate; a second gate formed on the substrate; and a potential measurement unit formed between the first gate and the second gate and configured to measure potential of the first gate and potential of the second gate, wherein channel portions are formed between the first gate and the potential measurement unit and between the potential measurement unit and the second gate.

The channel portions may include: a first drain source channel formed between the first gate and the potential measurement unit; a second drain source channel formed between the potential measurement unit and the second gate; a third drain source channel formed between the first gate and the potential measurement unit at a position spaced apart from the first drain source channel by a predetermined distance; and a fourth drain source channel formed between the potential measurement unit and the second gate at a position spaced apart from the second drain source channel by a predetermined distance.

The first gate, the potential measurement unit, and the second gate may be formed on the same straight line.

A first gap may be formed between the first gate and the potential measurement unit, a second gap may be formed between the potential measurement unit and the second gate, and the first gap and the second gap may be the same.

The biosensor may further include: a first drain formed at one side of the first drain source channel; a first source formed at another side of the first drain source channel; a second drain formed at one side of the second drain source channel; a second source formed at another side of the second drain source channel; a third drain formed at one side of the third drain source channel; a third source formed at another side of the third drain source channel; a fourth drain formed at one side of the fourth drain source channel; and a fourth source formed at another side of the fourth drain source channel.

The biosensor may further include: a first gate electrode connected to the first gate; a second gate electrode connected to the second gate; and a potential measurement unit electrode connected to the potential measurement unit, wherein the first gate electrode and the second gate electrode may be electrically connected to one end of a potential compensator configured to compensate the potential of the first gate and the potential of the second gate to a predetermined potential, and the potential measurement unit electrode may be electrically connected to another end of the potential compensator.

In order to achieve the objectives, a biosensor according to the present disclosure includes: a substrate; a gate formed on the substrate; and a potential measurement unit formed on the substrate at a position spaced apart by a predetermined distance, wherein a channel portion is formed between the gate and the potential measurement unit.

The channel portion may include: a first drain source channel formed between the gate and the potential measurement unit; and a second drain source channel formed between the gate and the potential measurement unit at a position spaced apart from the first drain source channel by a predetermined distance.

The gate and the potential measurement unit may be formed on the same straight line.

In order to achieve the objectives, a sensing system according to the present disclosure includes: a biosensor cartridge having a flow path through which a solution moves; a biosensor disposed in the biosensor cartridge; and a diagnostic device configured to analyze signals received from the biosensor, wherein the biosensor includes: a substrate; a first gate formed on the substrate; a second gate formed on the substrate; and a potential measurement unit formed between the first gate and the second gate and configured to measure potential of the first gate and potential of the second gate, and channel portions are formed between the first gate and the potential measurement unit and between the potential measurement unit and the second gate.

The channel portions may include: a first drain source channel formed between the first gate and the potential measurement unit; a second drain source channel formed between the potential measurement unit and the second gate; a third drain source channel formed between the first gate and the potential measurement unit at a position spaced apart from the first drain source channel by a predetermined distance; and a fourth drain source channel formed between the potential measurement unit and the second gate at a position spaced apart from the second drain source channel by a predetermined distance.

The first gate, the potential measurement unit, and the second gate may be formed in the same straight-line direction as a flow direction of the solution.

A first gap may be formed between the first gate and the potential measurement unit, a second gap may be formed between the potential measurement unit and the second gate, and the first gap and the second gap may be the same.

The diagnostic device may include a potential compensator configured to compensate potential in order to maintain potential of the first gate and potential of the second gate at a predetermined potential.

The biosensor may further include: a first gate electrode connected to the first gate; a second gate electrode connected to the second gate; and a potential measurement unit electrode connected to the potential measurement unit, wherein the first gate electrode and the second gate electrode may be electrically connected to one end of the potential compensator, and the potential measurement unit electrode may be electrically connected to another end of the potential compensator.

Since a straight electric field is applied to the channel portions from both the first gate and the second gate, a stable field effect can be generated. Further, by the structure of the first gate, the potential measurement unit, and the second gate, the flexibility in fluid movement direction is increased, so the sensing accuracy can be improved.

Since the first gate is disposed under the inlet port formed on the base frame of the biosensor cartridge and the second gate is disposed under the outlet port on the base frame of the biosensor cartridge, it is possible to always maintain the potential at a constant level, and accordingly, it is possible to reduce measurement noise and improve the sensing accuracy.

It is possible to always maintain the potential of the first gate and the second gate, which is applied to the channel portions through the potential compensator, at a constant level, so it is possible to reduce measurement noise and improve the sensing accuracy.

### BRIEF DESCRIPTION OF THE DRAWINGS

FIG. 1 is a view illustrating a biosensor cartridge and a diagnostic device according to an embodiment of the present disclosure;
FIG. 2 to FIG. 4 are views illustrating the biosensor cartridge according to an embodiment of the present disclosure,
FIG. 5 is a plan view illustrating the state in which an upper housing has been removed from FIG. 4;
FIG. 6 is an exploded perspective view of a frame according to an embodiment of the present disclosure;
FIG. 7 is a plan view illustrating a top frame according to an embodiment of the present disclosure;
FIG. 8 is a cross-sectional view of the frame according to an embodiment of the present disclosure;
FIG. 9 is a bottom view illustrating channels formed on the top frame according to an embodiment of the present disclosure;
FIG. 10 is a view illustrating combination of a biosensor and a printed circuit board with a frame in the biosensor cartridge according to an embodiment of the present disclosure;
FIG. 11 is a view illustrating a sensor coupling portion in the biosensor cartridge according to an embodiment of the present disclosure;
FIG. 12 is a view illustrating the state in which the sensor coupling portion has been coupled in the biosensor cartridge according to an embodiment of the present disclosure;
FIG. 13 is a cross-sectional view illustrating contact between the biosensor and the printed circuit board in the biosensor cartridge according to an embodiment of the present disclosure;
FIG. 14 and FIG. 15 are cross-sectional views illustrating arrangement of the biosensor and the printed circuit board and the arrangement of flow paths on the biosensor in the biosensor cartridge according to an embodiment of the present disclosure;
FIG. 16 is a view illustrating a process of diagnosing a sample solution introduced in a biosensor cartridge using a diagnostic device according to an embodiment of the present disclosure;
FIG. 17 is a cross-sectional view illustrating a biosensor in which a solution flows in accordance with an embodiment of the present disclosure;
FIG. 18 to FIG. 20 are views illustrating circuit arrangement of a biosensor according to an embodiment of the present disclosure;
FIG. 21 and FIG. 22 are views illustrating reduction of transfer curve noise according to an embodiment of the present disclosure; and
FIG. 23 and FIG. 24 are views illustrating potential compensation according to an embodiment of the present disclosure.

### DETAILED DESCRIPTION

Hereinafter, exemplary embodiments of the present disclosure are described in detail with reference to the accompanying drawings.

The present disclosure may be modified in various ways and implemented by various exemplary embodiments, so that specific exemplary embodiments are shown in the drawings and will be described in detail herein. This is not intended to limit the present disclosure to specific embodiments, and it should be understood to include all modifications, equivalents, and substitutions within the spirit and scope of the present disclosure.

In the description of the present disclosure, it will be understood that although the terms first and/or second, etc. may be used herein to describe various components, these elements should not be limited by these terms. The terms are used only to distinguish one component from another component. For example, the "first" component may be named the "second" component, and vice versa, without departing from the scope of the present disclosure.

The term "and/or" may include a combination of a plurality of related and described items or any one of a plurality of related and described terms.

It is to be understood that when one element is referred to as being "connected to" or "coupled to" another element, it may be connected directly to or coupled directly to another element or be connected to or coupled to another element with the other element therebetween. On the other hand, it should be understood that when one element is referred to as being "connected directly to" or "coupled directly to" another element, it may be connected to or coupled to another element without the other element therebetween.

Terms used in the present disclosure are used only in order to describe specific exemplary embodiments rather than limiting the present disclosure. Singular forms are intended to include plural forms unless the context clearly indicates otherwise.

It will be further understood that the terms "comprises" or "have" used in this specification specify the presence of stated features, steps, operations, components, parts, or a combination thereof, but do not preclude the presence or addition of one or more other features, numerals, steps, operations, components, parts, or a combination thereof.

Unless defined otherwise, it is to be understood that all the terms used in the specification including technical and scientific terms have the same meanings as those that are generally understood by those who skilled in the art. It will be further understood that terms defined in dictionaries that are commonly used may be interpreted as having meanings that are consistent with their meanings in the context of the relevant art and may not be interpreted in an idealized or overly formal sense unless expressly so defined herein.

Further, the following embodiments are provided to give a more complete explanation to those skilled in the art, and the shapes and sizes of the elements in the drawings may be exaggerated for clearer explanation.

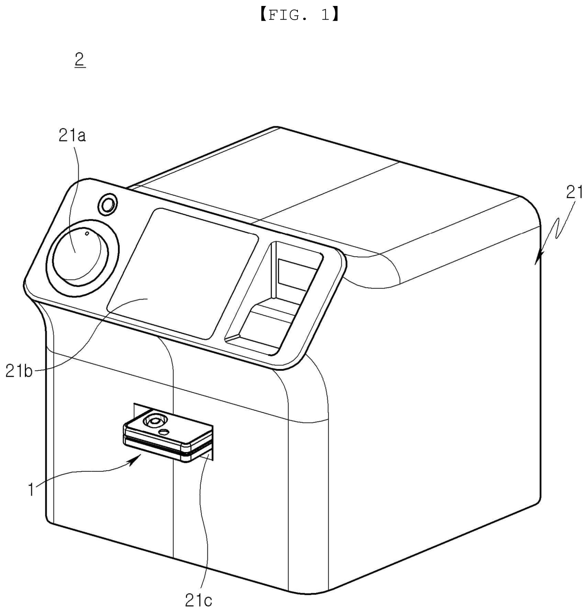

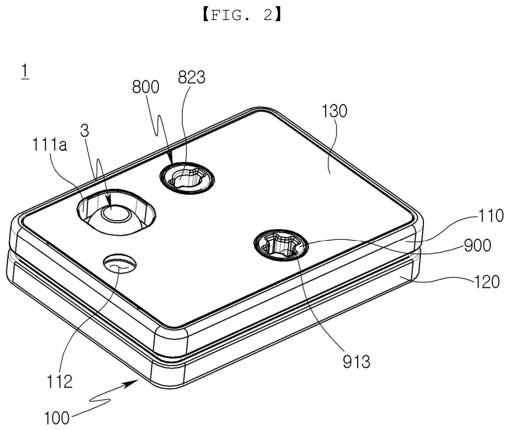

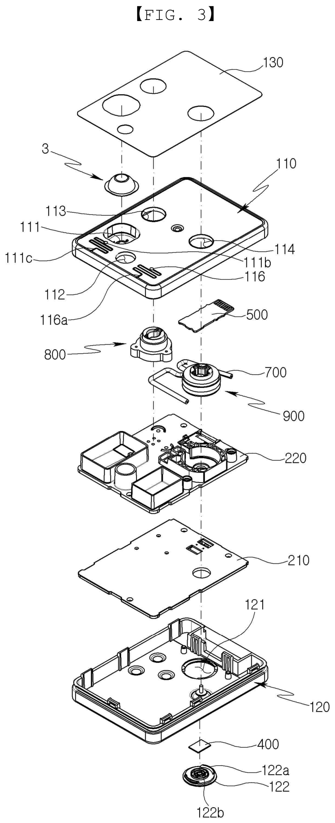

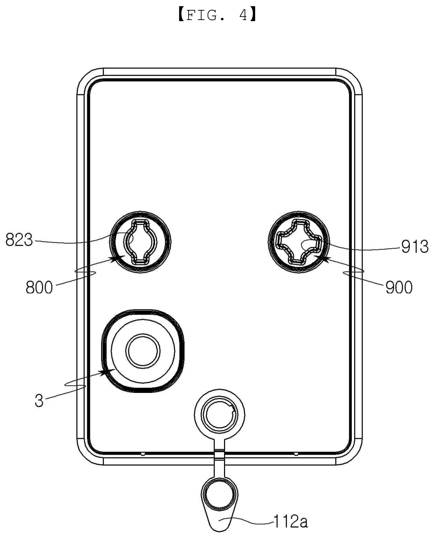

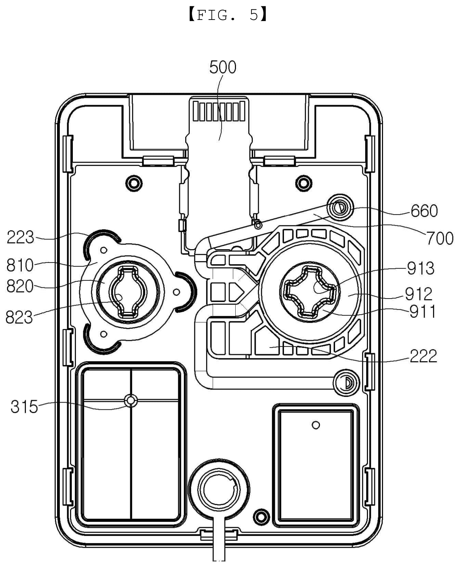

FIG. 1 is a view illustrating a biosensor cartridge and a diagnostic device according to an embodiment of the present disclosure. FIG. 2 to FIG. 4 are views illustrating the biosensor cartridge according to an embodiment of the present disclosure. FIG. 5 is a plan view illustrating the state in which an upper housing has been removed from FIG. 4.

Referring to FIG. 1 to FIG. 5, the biosensor cartridge 1 according to an embodiment of the present disclosure is coupled with the diagnostic device 2 and can sense bio-substances, thereby being able to diagnose diseases, etc. As an embodiment, the biosensor cartridge 1 can be inserted into the diagnostic device 2 while being arranged in the horizontal direction. The biosensor cartridge 1 can enable a biosensor 400 to generate electrochemical reactions with bio-substances by making a buffer solution and a sample solution flow inside, and can transmit corresponding electrical variation to the diagnostic device 2 through a printed circuit board 500.

The biosensor cartridge 1 according to an embodiment of the present disclosure may include a housing 100, a frame 200, a tank 300, a biosensor 400, a printed circuit board 500, a channel 600, a tube 700, a valve unit 800, and a pump unit 900.

The frame 200 may be accommodated in the housing 100, the tank 300 may be formed on the frame 200, and the channel 600 may be formed inside the frame 200. The tube 700, the valve unit 800, and the pump unit 900 may be coupled to the frame 200, and the biosensor 400 and the printed circuit board 500 may be detachably coupled to the frame 200.

In the present disclosure, the direction in which a buffer solution is introduced may be referred to as the upper side with respect to the frame 200, the direction opposite to the upper side with respect to the frame 200 may be referred to as a lower side, and the direction in which the biosensor cartridge 1 is inserted into the diagnostic device 2 may be referred to as the front. That is, the direction in which the printed circuit board 500 is arranged with respect to the housing 100 may be referred to as the front. Further, the direction opposite to the front may be referred to as the rear. Further, when viewing the rear end of the housing 100 toward the front, the direction to the left may be referred to as the left side, and the direction to the right may be referred to as the right side.

The housing 100 can form the external appearance of the biosensor cartridge 1 and can accommodate the frame 200, the tank 300, the biosensor 400, the printed circuit board 500, the channel 600, the tube 700, the valve unit 800, and the pump unit 900 therein.

The housing 100 may include an upper housing 110 and a lower housing 120.

As an embodiment, the upper housing 110 is formed in a rectangular box shape with an open bottom, and a buffer solution introduction hole 111, a sample solution introduction hole 112, a valve connection hole 113, and a pump connection hole 114 may be formed on the top of the upper housing 110.

The buffer solution introduction hole 111 may be formed to introduce a buffer solution. The buffer solution introduction hole 111 may be formed in a blister accommodation groove 111a. The blister accommodation groove 111a may be disposed directly over a buffer solution tank 310. Accordingly, the buffer solution introduction hole 111 may be disposed directly over the buffer solution tank 310 and may be formed in fluid communication with the internal space of the buffer solution tank 310.

A buffer blister 3 may be coupled to the blister accommodation groove 111a. The blister accommodation groove 111a may be recessed downward on the top surface of the upper housing 110 to correspond to the shape of the buffer blister 3. As an embodiment, the blister accommodation groove 111a may be recessed in the form of a rectangular groove or circular groove on the top surface of the upper housing 110. According to this configuration, a buffer solution can flow into the buffer solution tank 310 through the buffer solution introduction hole 111 upon bursting of the buffer blister 3 in the blister accommodation groove 111a.

The pump unit 900 is rotatably coupled to the frame 200 and presses the tube 700 by rotating, thereby being able to generate a flow-driving force to a buffer solution or a sample solution flowing through the channel 600.

The pump unit 900 may include a pump knob 910 and a bearing 920.

The pump knob 910 may be disposed on the top surface of the top frame 220. The pump knob 910 may be rotatably coupled in the tube accommodation portion 222. The pump knob 910 may be rotatably accommodated in the pump accommodation groove 222a.

In detail, the pump knob 910 includes a shaft 911, a supporting portion 912, and a driving groove 913.

At least one or more ventilation holes 111b and 116 may be formed on the top surface of the upper housing 110. The ventilation holes 111b and 116 may be formed so that the air in the housing 100 can be discharged to the outside. A first ventilation hole 111b may be formed on the top surface of the upper housing 110. The first ventilation hole 111b may be disposed directly over the buffer solution tank 310. The first ventilation hole 111b may be formed in fluid communication with the internal space of the buffer solution tank 310. When a buffer solution is introduced into the buffer solution tank 310, the air in the buffer solution tank 310 can be discharged to the outside through the first ventilation hole 111b. Accordingly, there is an advantage that it is possible to prevent the air pressure in the buffer solution tank 310 from increasing and reduce the possibility of a buffer solution mixing with air.

A first ventilation flow path 111c may be further formed on the top surface of the upper housing 110. The first ventilation flow path 111c may be formed in fluid communication with the first ventilation hole 111d and may be formed in the form of a groove along the top surface of the upper housing 110. As an embodiment, the ventilation flow path 111c may be formed not only in the form of a straight, but also in a shape bent a plurality of times on the top surface of the upper housing 110. This is for ensuring a maximum flow path length in a limited area. When a label 130 is bonded to the top surface of the upper housing 110, the first ventilation flow path 111c forms a space between the upper housing 110 and the label 130, whereby it is possible to accommodate the air discharged through the first ventilation hole 111b.

The sample solution introduction hole 112 may be formed to introduce a sample solution. As an embodiment, the sample solution introduction hole 112 may be disposed directly over a sample solution tank 320. The sample solution introduction hole 112 may be formed in fluid communication with the internal space of the sample solution tank 320. As an embodiment, a cap 112a may be detachably coupled to the sample solution introduction hole 112. When the cap 112 is coupled, the sample solution introduction hole 112 can be obstructed. Further, when the cap 112a is separated, the sample solution introduction hole 112 is opened, so a sample solution can be introduced. When the sample solution introduction hole 112 is obstructed with the cap 112a after a sample solution is introduced, it is possible to prevent foreign substances from entering the sample solution introduction hole 112.

The valve connection hole 113 may be formed to pass a portion of the valve unit 800. The valve connection hole 113 may be formed over a valve coupling portion 223. The valve connection hole 113 may be formed in the form of a circular hole and a valve knob 820 may be arranged to extend through the valve connection hole 113. The valve knob 820 can be rotated in the valve connection hole 113.

At least a portion of the valve knob 820 may be rotatably accommodated in the valve housing 810.

A knob groove 823 may be formed at the valve knob 820 such that an external force can be applied. The knob groove 823 can be coupled with a valve actuator (not shown) provided in the diagnostic device 2 when the biosensor cartridge 1 is coupled to the diagnostic device 2.

The pump connection hole 114 may be formed to pass a portion of the pump unit 900. The pump connection hole 114 may be formed over a valve coupling portion 223. The pump connection hole 114 may be formed over a pump accommodation groove 222a. The pump connection hole 114 may be formed in the form of a circular hole and a pump knob 910 may be arranged to extend through the pump connection hole 114. The pump knob 910 can be rotated in the pump connection hole 114.

A supporting protrusion 115 for supporting the printed circuit board 500 toward the inside of the housing 100 may be formed on the top surface of the upper housing 110. The supporting protrusion 115 may be disposed directly over a substrate coupling portion 221 of the frame 200. The supporting protrusion 115 can support the printed circuit board 500 in contact with the top surface of the printed circuit board 500.

A second ventilation hole 116 may be further formed on the top surface of the upper housing 110. The second ventilation hole 116 may be disposed directly over a waste solution tank 330. The second ventilation hole 116 may be formed in fluid communication with the internal space of the waste solution tank 330. When a buffer solution or a sample solution is introduced into the waste solution tank 330, the air in the waste solution tank 330 can be discharged to the outside through the second ventilation hole 116. Accordingly, it is possible to prevent the air pressure in the waste solution tank 330 from increasing.

A second ventilation flow path 116a may be further formed on the top surface of the upper housing 110. The second ventilation flow path 116a may be formed in fluid communication with the second ventilation hole 116 and may be formed in the form of a groove along the top surface of the upper housing 110. The second ventilation flow path 116a may be formed not only in the form of a straight line, but also in a shape bent a plurality of times on the top surface of the upper housing 110. This is for ensuring a maximum flow path length in a limited area. According to this configuration, when a label 130 is bonded to the top surface of the upper housing 110, the second ventilation flow path 116a forms a space between the upper housing 110 and the label 130, whereby it is possible to accommodate the air discharged through the second ventilation hole 116.

The lower housing 120 is combined with the upper housing 110, thereby being able to form a space for accommodating the frame 200, the tank 300, the biosensor 400, the printed circuit board 500, the channel 600, the tube 700, the valve unit 800, and the pump unit 900 therein.

As an embodiment, the lower housing 120 may be formed in the form of a rectangular box with an open top and may be combined with the upper housing 110. A plurality of hooks protruding toward the upper housing 110 may be formed on the side walls of the lower housing 120 and may be fitted in grooves (not shown) formed on the side walls of the upper housing 110.

A sensor introduction hole 121 through which the biosensor 400 can be introduced may be formed on the bottom surface of the lower housing 120. As an embodiment, the sensor introduction hole 121 may be formed in the forms of a circular hole and a pair of cover coupling portions 121a may protrude radially inwardly from at least a portion of the internal circumferential surface thereof. The cover coupling portions 121a may be supported by being coupled with hooks 122a of a sensor cover 122a.

The sensor cover 122 may be coupled to the bottom surface of the lower housing 120. The sensor cover 122 can cover the sensor introduction hole 121 and can prevent separation of the biosensor 400 coupled to the frame 200.

The sensor cover 122 may include hooks 122a, a sensor supporting portion 122b, and a coupling guide portion 122c. The entire sensor cover 122 may be formed in a disc shape, the hooks 122a and the sensor supporting portion 122b may protrude from the top surface of the cover 122, and the coupling guide groove 122c may be recessed on the bottom surface of the sensor cover 122. The diameter of the sensor cover 122 may be set to correspond to the diameter of the sensor introduction hole 121. As an embodiment, the diameter of the sensor cover 122 may be set to be the same as the diameter of the sensor introduction hole 121.

The hooks 122a may protrude upward from the top surface of the sensor cover 122 and the upper ends thereof may protrude radially outwardly. The hooks 122a may be formed as a pair at positions facing each other and may be formed within a predetermined angular angle in the circumferential direction. When the hooks 122a are inserted into the sensor introduction hole 121 where the cover coupling portions 121a are not formed and then the sensor cover 122 is rotated, the hooks 122a can be disposed over the cover coupling portions 121a. Accordingly, the cover coupling portions 121a are disposed between the hooks 122a and the top surface of the sensor cover 122, whereby it is possible to prevent separation of the sensor cover 122.

The sensor supporting portion 122b may protrude upward in the circumferential direction on the top surface of the sensor cover 122. The sensor supporting portion 122b may protrude in the form of a circular rib around the center of the sensor cover 122 in the radial direction. The sensor supporting portion 122b may protrude to be able to support the bottom surface of the biosensor 400 in contact with the bottom surface. When the sensor cover 122 is coupled to the lower housing 120 and obstructs the sensor introduction hole 121, the sensor supporting portion 122b can support the biosensor 400 in contact with it. Accordingly, the biosensor 400 is prevented from shaking, whereby it is possible to prevent errors in measurement values of the biosensor 400.

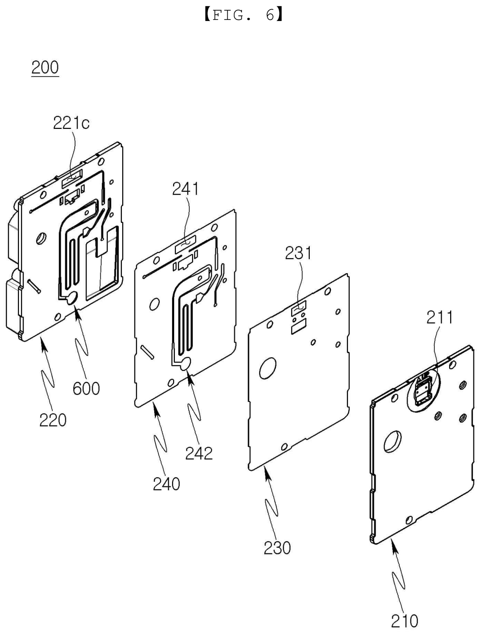

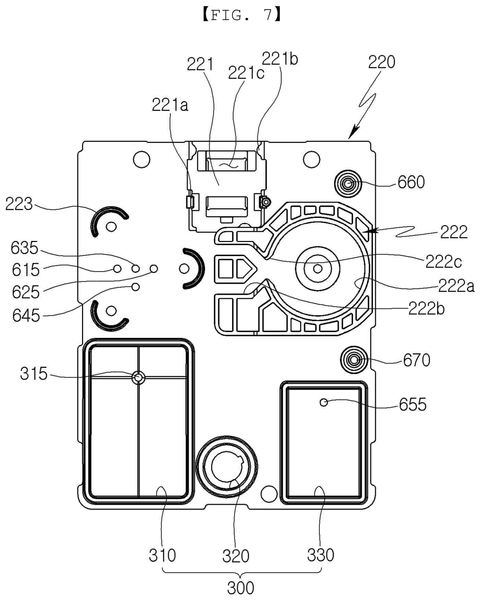

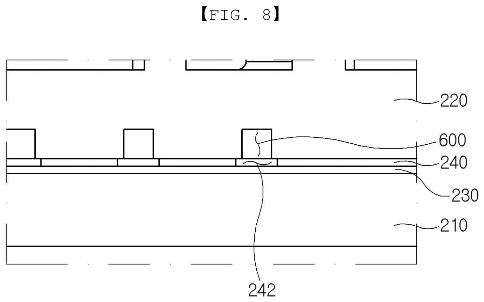

FIG. 6 is an exploded perspective view of a frame according to an embodiment of the present disclosure. FIG. 7 is a plan view illustrating a top frame according to an embodiment of the present disclosure. FIG. 8 is a cross-sectional view of the frame according to an embodiment of the present disclosure.

Referring to FIG. 6 to FIG. 8, the frame 200 may be disposed in the housing 100 and the channel 600 through which a buffer solution and a sample solution flows may be formed therein.

The biosensor 400 and the printed circuit board 500 are detachably coupled to the frame 200 so that the biosensor 400 can detect a bio-substance from a sample solution flowing through the channel 600.

The frame 200 may include a base frame 210, a top frame 220, a hydrophilic adhesive layer 230, and a fine flow path-forming adhesive layer 240. As an embodiment, the hydrophilic adhesive layer 230 may be stacked on the base frame 210, the fine flow path-forming adhesive layer 240 may be stacked on the hydrophilic adhesive layer 230, and the top frame 220 may be stacked on the fine flow path-forming adhesive layer 240.

The biosensor 400 can be detachably coupled to the base frame 210. The base frame 210 can support the biosensor 400 though coupling to the biosensor 400. As an embodiment, the biosensor 210 may be formed in the form of a substantially rectangular flat plate and may have the sensor coupling portion 211 coupled with the biosensor 400.

The sensor coupling portion 211 can be detachably coupled with the biosensor 400. The entire sensor coupling portion 211 may be formed in the form of a hole corresponding to the shape of the biosensor 400 and a frame crossing the hole in the short axis direction may be formed. A pair of ports 631 and 632 may be formed on the frame. As an embodiment, the sensor coupling portion 211 may be formed in the form of a rectangular hole, of which the front-rear diameter and the left-right diameter may be the same as the front-rear length and the left-right width of the biosensor 400, respectively.

The biosensor 400 can be fitted in the sensor coupling portion 211. At least a portion of the side wall surrounding the sensor coupling portion 211 may be thicker than the biosensor 400. Accordingly, when the biosensor 400 is fitted in the sensor coupling portion 211, the biosensor 400 can be stably supported.

Holes for fixing the valve unit 800 and the pump unit 900 may be formed at the base frame 210, and fixing members such as screws may pass through the holes and be coupled with the valve unit 800 and the pump unit 900 disposed over the top frame 220.

The tank 300 may be formed on the top frame 220. As an embodiment, the tank 300 may be formed on the top surface of the top frame 220.

The channel 600 may be formed on the top frame 220. As an embodiment, the channel 600 may be formed on the bottom surface of the top frame 220.

The top frame 220 may be made of a resin material. As an embodiment, the top frame 220 may be made of a Poly Methyl Methacrylate (PMMA) resin. This allows for mass production while precisely forming the channel 600 through injection molding. Further, it is possible to easily bond the top frame 220 and the base frame 210 using a tape.

The substrate coupling portion 221 may be formed on the top surface of the top frame 220. The printed circuit board 500 can be detachably coupled to the substrate coupling portion 221. The substrate coupling portion 221 may be disposed at a position facing the sensor coupling portion 211. That is, at least a portion of the substrate coupling portion 221 may be disposed over the sensor coupling portion 211. Accordingly, it is possible to minimize the distance between the biosensor 400 and the printed circuit board 500 and it is possible to quickly and accurately transmit information sensed by the biosensor 400 to the printed circuit board 500.

The substrate coupling portion 221 may include coupling guide portions 221a that guide slide coupling of the printed circuit board 500. The coupling guide portions 221a may be provided as a pair facing each other, protruding upward from the top surface of the top frame 220, and then bending and extending toward each other. As an embodiment, the gap between the pair of coupling guide portions 221a may be the same as the width of the printed circuit board 500. The pair of coupling guide portions 221a can prevent the printed circuit board 500 from shaking in the horizontal direction by stably supporting the printed circuit board 500. As an embodiment, the protrusion height of the pair of coupling guide portions 221a may be the same as or slightly larger than the thickness of the printed circuit board 500. Accordingly, it is possible to the printed circuit board 500 from moving in the vertical direction.

The substrate coupling portion 221 may further include substrate supporting portions 221b that guide the coupling position of the printed circuit board 500 and support the printed circuit board 500. The substrate supporting portions 221b may be provided as a pair facing each other and protruding upward on the top surface of the top frame 220. The substrate supporting portions 221b may be formed to correspond to the shapes of both ends of the printed circuit board 500in the width direction (short axis direction). As an embodiment, when a semicircular groove is formed at both ends of the printed circuit board 500 in the width direction, the pair of substrate supporting portions 221b may be formed in semicircular shapes protruding toward. As an embodiment, the shortest distance between the pair of substrate supporting portions 221b may be the same as the shortest distance of the printed circuit board 500 in the width direction. Accordingly, when the printed circuit board 500 is coupled, the coupling position can be guided while it is fitted to the substrate supporting portions 221b, and it is possible to prevent the printed circuit board 500 from moving in the insertion direction.

As a result, the substrate coupling portion 221 can prevent the printed circuit board 500, which has been coupled, from shaking in the horizontally direction and the vertical direction through the coupling guide portions 221a and the substrate supporting portions 221b. The substrate coupling portion 221 stably support the printed circuit board 500 that has been coupled, whereby there is an effect that it is possible to prevent errors in data due to shaking of the printed circuit board 500.

Clip accommodation holes 221c that accommodate contact clips 450 may be formed at the substrate coupling portion 221. The clip accommodation holes 221c may be disposed as a pair on the substrate coupling portion 221. As an embodiment, at least a portion of one of the pair of clip accommodation holes 221c may be disposed between the pair of coupling guide portions 221a, and at least a portion of the other one of the pair of clip accommodation holes 221c may be disposed between the pair of substrate supporting portions 221b. Accordingly, it is possible to prevent the contact clips 450 accommodated in the clip accommodation holes 221c from being disengaged from a predetermined position.

The pair of clip accommodation holes 221c may be formed in fluid communication with the sensor coupling portion 211. At least a portion of each of the pair of clip accommodation holes 221c may be disposed at a position facing the sensor coupling portion 211. As an embodiment, the sensor coupling portion 211 may be disposed between the pair of clip accommodation holes 221c such that a portion of each of both ends of the sensor coupling portion 211 in the longitudinal direction (front-rear direction) overlaps at least a portion of each of the pair of clip accommodation holes 221c. According to this configuration, a step to which the contact clips 450 can be formed with the base frame 210 and the top frame 220 stacked. Accordingly, the contact clips 450 themselves can be in direct contact with the biosensor 400 and the printed circuit board 500, and the accuracy of data transmission through the contact clips 450 can be improved.

A tube accommodation portion 222 may be formed on the top frame 220. The tube accommodation portion 222 may protrude upward from the top surface of the top frame 220. The tube accommodation portion 222 can guide the arrangement position of the tube 700 on the top frame 220.

The tube accommodation portion 222 may convexly protrude from the top surface of the top frame 220 and may have a pump accommodation groove 222a and tube guide grooves 222b therein.

The pump accommodation groove 222a can accommodate at least portions of the tube 700 and the pump unit 900 therein. The tube 700 may be circumferentially disposed and at least a portion of the pump unit 900 may be rotatably accommodated inside the wound tube 700. At least a portion of the pump unit 900 may be disposed in the pump accommodation groove 222a in contact with the tube 700. As an embodiment, the pump accommodation groove 222a may be formed in the form of a circular groove and the tube 700 may be wound along the inner circumference thereof, and the pump unit 900 may be rotatably disposed inside the tube 700. When the pump unit 900 is rotated, the tube 700 disposed between the side wall of the pump accommodation groove 222a and the pump unit 900 can be compressed.

The tube guide grooves 222b are formed in fluid communication with the pump accommodation groove 222a and can accommodate at least a portion of the tube 700. A first side and a second side of the tube 700 wound in the pump accommodation groove 222a can be accommodated in the tube guide grooves 222b, respectively. The tube guide grooves 222b can accommodate the tube 700 such that the first side and the second side of the tube 700 cross each other. That is, the groove accommodating the first side of the tube 700 and the groove accommodating the second side of the tube 700 may merge into a single groove, and the merged point 222c may be formed in fluid communication with the pump accommodation groove 222a. Accordingly, when the pump 900 is rotated, at least a portion of the tube 700 can remain in contact with the pump unit 900, and it is possible to prevent backflow of a solution flowing through the tube 700 when the pump 900 is rotated.

A valve coupling portion 223 may be formed on the top frame 223. The valve coupling portion 223 may protrude upward from the top surface of the top frame 220. As an embodiment, the valve coupling portion 223 may protrude in the form of a rib from the top surface of the top frame 220. The valve coupling portion 223 may be formed to surround the outer side of at least a portion of the valve unit 800. Accordingly, the valve coupling portion 223 can guide the coupling position of the valve unit 800.

A plurality of ports may be formed on the top frame 223. The ports can provide spaces through which a buffer solution or a sample solution flows into the channel 600 or into which a buffer solution or a sample solution is discharged from the channel 600. A buffer solution inlet port 315, a buffer solution port 615, a sample solution port 625, a sensing port 635, a prefill port 645, a waste solution port 655, a first tube connection port 660, and a second tube connection port 670 may be formed on the top frame 220. The buffer solution inlet port 315 may be disposed in the buffer solution tank 310 to enable the buffer solution in the buffer solution tank 310 to flow into the channel 600.

The buffer solution port 615, the sample solution port 625, the sensing port 635, and the prefill port 645 may be arranged to be connected by the valve unit 800. As an embodiment, the buffer solution port 615, the sample solution port 625, and the prefill port 645 may be arranged on a coaxial circle centered around the sensing port 635. In this configuration, the buffer solution port 615, the sample solution port 625, and the prefill port 645 may be arranged at predetermined angular intervals around the sensing port 635.

The first tube connection port 660 and the second tube connection port 670 may be connected with the tube 700. The first tube connection port 660 and the second tube connection port 670 may be disposed adjacent to the pump unit 900. As an embodiment, the second tube connection port 670 may be disposed on one side of the pump unit 900 in the longitudinal direction of the top frame 220, and the first tube connection port 660 may be disposed on another side of the pump unit 900 in the longitudinal direction of the top frame 220.

In the case of biosensor cartridges of the related art, a channel was formed inside a frame to allow liquid to flow, but, during testing of sample solutions, the flow rate of the solutions was not constant, which results in a limitation in the accuracy of sensing.

In order to solve this problem, hydrophilic coating was applied to a base frame in some cases, but there was the drawback that due to the addition of the coating process, production costs increased, while the defect rate also increased due to coating irregularities.

Accordingly, in the present disclosure, the flow rate of a solution can be maintained at a constant level through the hydrophilic adhesive layer 230 while minimizing production cost increases and defect rates.

The hydrophilic adhesive layer 230 may be disposed between the base frame 210 and the top frame 220. The hydrophilic adhesive layer 230 may be disposed between the base frame 210 and the fine flow path-forming adhesive layer 240. For example, the hydrophilic adhesive layer 230 may be a hydrophilic tape or a hydrophilic film. The hydrophilic adhesive layer 230 may be disposed on the base frame 210, thereby making it possible to facilitate the flow of the fluid flowing through the channel 600. Further, the hydrophilic adhesive layer 230 provides the effect that the flow rate of a solution can be stably maintained. Further, there is an advantage that bonding can be achieved through a simple process of placing the hydrophilic adhesive layer 230, fine flow path-forming adhesive layer 240, and the top frame 220 over the base frame 210 and then pressing them.

A shape corresponding to the shape of the top frame 220 may be formed at the hydrophilic adhesive layer 230. As an embodiment, clip accommodation holes 231 may be formed at the hydrophilic adhesive layer 230. The clip accommodation holes 231 of the hydrophilic adhesive layer 230 may be formed at positions facing the clip accommodation holes 221c of the top frame 220 and may be formed in the same size.

A shape corresponding to the shape of the base frame 210 may be formed at the hydrophilic adhesive layer 230. As an embodiment, ports may be formed at the hydrophilic adhesive layer 230. The ports of the hydrophilic adhesive layer 230 may be formed at positions facing the ports 631a and 632a of the base frame 210 and may be formed in the same size.

The fine flow path-forming adhesive layer 240 may be disposed between the hydrophilic adhesive layer 230 and the top frame 220. The fine flow path-forming adhesive layer 240 can bond the hydrophilic adhesive layer 230 and the top frame 220. A shape corresponding to the shape of the top frame 220 may be formed at the fine flow path-forming adhesive layer 240.

A channel slit 242 that is in fluid communication with the channel 600 formed at the top frame 220 may be formed at the fine flow path-forming adhesive layer 240. The channel slit 242 may be formed at a position facing the channel 600. As an embodiment, the width of the channel slit 242 may be larger than the width of the channel 600. Accordingly, it is possible to prevent errors in the flow of solutions even through there is an error in the position of the channel slit 242.

Clip accommodation holes 241 may be formed at the fine flow path-forming adhesive layer 240. The clip accommodation holes 241 of the fine flow path-forming adhesive layer 240 may be formed at positions facing the clip accommodation holes 221c of the top frame 220 and may be formed in the same size.

The tank 300 is formed on the top surface of the frame 200 and can provide a space in which a buffer solution and/or a sample solution can be accommodated. As an embodiment, the tank 300 may protrude from the top surface of the top frame 220 to surround a predetermined space.

The tank 300 may include a buffer solution tank 310. The buffer solution tank 310 can receive a buffer solution, accommodate the buffer solution at least temporarily, and send the buffer unit to the channel 600.

The buffer solution tank 310 may be disposed at the rear (a side in the longitudinal direction) of the frame 200. The buffer solution tank 310 may be disposed opposite the substrate coupling portion 221 on the frame 200.

The buffer solution tank 310 may be disposed at the left side (a side in the longitudinal direction) of the frame 200. The buffer solution tank 310 may be disposed opposite the waste solution tank 330 on the frame 200.

The buffer solution tank 310 may protrude in the form of a wall from the top surface of the top frame 220. As an embodiment, the buffer solution tank 310 may protrude in the form of a rectangular wall. The buffer solution inlet port 315 may be formed on the top frame 220 and may be formed in fluid communication with the buffer solution channel 610. The buffer solution inlet port 315 may be formed in the buffer solution tank 310.

An inclined surface 311 and a guide groove that guide a buffer solution to flow to the buffer solution inlet port 315 may be formed in the buffer solution tank 310. As an embodiment, the inclined surface may be formed to slope downward from the rear end of the buffer solution tank 310 toward the front. The inclined surface may be formed to slope downward from both sides toward the center of the buffer solution tank 310 in the left-right direction. A guide groove may be formed in the front-rear direction on the internal bottom surface of the buffer solution tank 310. The buffer solution inlet port 315 may be formed on the guide groove.

The buffer solution tank 310 can surround the space into which a buffer solution flows. Therefore, a buffer solution can be accommodated in the buffer solution tank 310 and the buffer solution can be discharged to the channel 600 by the operation of the pump unit 900.

The tank 300 may include a sample solution tank 320. The sample solution tank 320 can receive a sample solution, accommodate the sample solution at least temporarily, and send the sample unit to the channel 600.

The sample solution tank 320 may be disposed at the rear side on the frame 200. The sample solution tank 320 may be disposed opposite the substrate coupling portion 221 on the frame 200.

At least a portion of the sample solution tank 320 may be disposed at the center of the frame 200 in the left-right direction. The sample solution tank 320 may be disposed between the buffer solution tank 310 and the waste solution tank 330.

The sample solution tank 320 may protrude in the form of a wall from the top surface of the top frame 220. As an embodiment, the sample solution tank 320 may protrude in the form of a circular wall. The top frame 220 may be formed with the bottom of the internal space of the sample solution tank 320 at least partially open. The internal space of the sample solution tank 320 may be formed in fluid communication with the sample solution channel 620.

The sample solution tank 320 can surround the space into which a sample solution flows. Therefore, a sample solution can be accommodated in the sample solution tank 320 and the sample solution can be discharged to the channel 600 by the operation of the pump unit 900.

The tank 300 may include a waste solution tank 330. The waste solution tank 330 can receive a waste solution and store the waste solution.

The waste solution tank 330 may be disposed at the rear side on the frame 200. The waste solution tank 330 may be disposed opposite the substrate coupling portion 221 on the frame 200. The waste solution tank 330 may be disposed at the right side on the frame 200.

The waste solution tank 330 may protrude in the form of a wall from the top surface of the top frame 220. As an embodiment, the waste solution tank 330 may protrude in the form of a rectangular wall. The waste solution port 655 may be formed on the top frame 220 and may be formed in fluid communication with the waste solution channel 650. The waste solution port 655 may be formed in the waste solution tank 330.

The waste solution tank 330 can surround the space into which a waste solution flows. A waste solution can be sent into and stored in the waste solution tank 330 from the channel 600 by the operation of the pump unit 900.

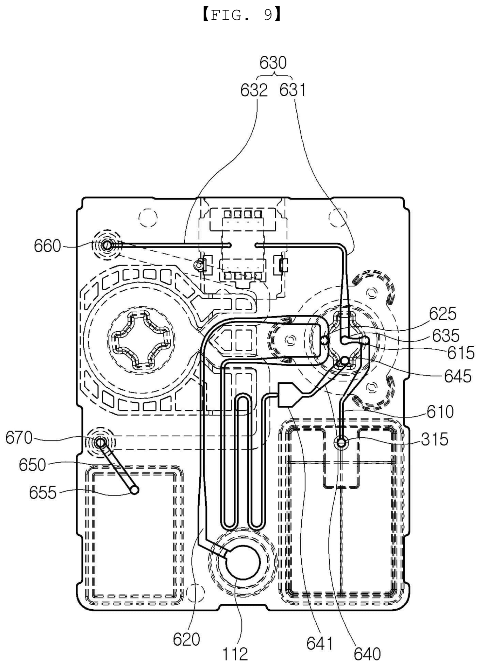

FIG. 9 is a bottom view illustrating channels formed on the top frame according to an embodiment of the present disclosure.

Referring to FIG. 9, the channel 600 is formed inside the frame 200 and can provide flow paths through which a buffer solution or a sample solution can flow. The channel 600 may be formed on the bottom surface of the top frame 220.

The channel 600 may include a buffer solution channel 610 that is connected with the buffer solution tank 310 and through which a buffer solution flows. A first side of the buffer solution channel 610 may be in fluid communication with the buffer solution inlet port 315. The first side of the buffer solution channel 610 can be in fluid communication with the internal space of the buffer solution tank 310 through the buffer solution inlet port 315. A second side of the buffer solution channel 610 may be in fluid communication with the buffer solution port 615. The second side of the buffer solution channel 610 can be brought into fluid communication with the sensing channel 630 through the buffer solution port 615, depending on the operation of the valve unit 800.

The buffer solution channel 610 can guide the buffer solution flowing in the buffer solution tank 310 to the valve unit 800. As an embodiment, the buffer solution channel 610 may be formed in the longitudinal direction (long axis direction) of the frame 200.

The buffer solution channel 610 may be formed in a shape bent at least once at a predetermined angle. As an embodiment, the buffer solution channel 610 may be formed to overall have two bent portions in the longitudinal direction (long axis direction) of the frame 200.

The buffer solution inlet port 315 can function as an inlet of the buffer solution channel 610 and the buffer solution port 615 can function as an outlet of the buffer solution port 615.

The buffer solution channel 610 may be formed such that the width of the inlet side and the width of the outlet side are different. As an embodiment, the buffer solution channel 610 may be formed such that the width of the outlet side is larger than the width of the inlet side. Accordingly, a buffer solution can be sufficiently present at the discharge port side of the buffer solution channel 610, it is possible to prevent the flow rate of a buffer solution passing through the valve unit 800 from decreasing, and the flow velocity of the buffer solution can be stably maintained.

The channel 600 may include a sample solution channel 620 that is connected with the sample solution tank 320 and through which a sample solution flows. A first side of the sample solution channel 620 may be in fluid communication with the internal space of the sample solution tank 320. A second side of the sample solution channel 620 may be in fluid communication with the sample solution port 625. The second side of the sample solution channel 620 can be brought into fluid communication with the sensing channel 630 through the sample solution port 625, depending on the operation of the valve unit 800.

The sample solution channel 620 can guide the sample solution flowing in the sample solution tank 320 to the valve unit 800. As an embodiment, the sample solution channel 620 may be formed in a direction crossing the longitudinal direction (long axis direction) of the frame 200 from the sample solution tank 320, then bent and extended in the longitudinal direction of the frame 200, and then bent and formed in the a direction crossing the longitudinal direction. The internal space of the sample solution tank 320 can function as an inlet of the sample solution channel 620 and the sample solution port 625 can function as an outlet of the sample solution channel 620.

The diameter of the internal space of the sample solution tank 320 may be larger than the width of the outlet side of the sample solution channel 620. The width of at least a portion of the sample solution channel 620 may be changed. As an embodiment, the width of the inlet side and the width of the outlet side of the sample solution channel 620 may be the same and a section in which the width decreases may be formed therebetween. Accordingly, it is possible to prevent the flow rate of a sample solution flowing through the sample solution channel 620 from momentarily decreasing through the operation of the pump unit 900, and the flow velocity of the sample solution can be stably maintained.

The channel 600 may include a sensing channel 630 connected with the buffer solution channel 610 and the sample solution channel 620 and guiding a buffer solution or a sample solution to the biosensor 400.

A first side of the sensing channel 630 may be in fluid communication with the sensing port 635. A second side of the sensing channel 630 may be in fluid communication with the first tube connection port 660. The second side of the sensing channel 630 can be brought into fluid communication with the channel formed in the tube 700 through the first tube connection port 660, depending on the operation of the valve unit 800.

The sensing channel 630 can guide a buffer solution or a sample solution flowing therein through the valve unit 800 to the biosensor 400 to pass through the biosensor 400.

The sensing channel 630 may include a first sensing channel 631 and a second sensing channel 632.

The first sensing channel 631 can guide a buffer solution or a sample solution that has passed through the valve unit 800 to the biosensor 400. The first sensing channel 631 may be formed in the longitudinal direction (long axis direction) of the frame 200 from the sensing channel 630, and then bent and formed in a direction crossing the longitudinal direction. As an embodiment, the first sensing channel 631 may be formed in the longitudinal direction (long axis direction) of the frame 200 from the sensing channel 635, and then bent and formed in the width direction. A second side of the first sensing channel 631 may be in fluid communication with the internal space of the sensor coupling portion 211. The first sensing channel 631 enables a buffer solution or a sample solution to flow to the internal space of the sensor coupling portion 211 through the inlet port 631a formed at the base frame 210.

A buffer solution or a sample solution that has passed through the first sensing channel 631 can flow on the top surface of the biosensor 400.

The sensing port 635 can function as an inlet of the first sensing channel 631 and the sensor coupling portion 211 can function as an outlet of the first sensing channel 631.

The width of the inlet side of the first sensing channel 631 may be larger than the width of the outlet side of the first sensing channel 631. Accordingly, a buffer solution or a sample solution can be sufficiently present at the inlet side of the first sensing channel 631, it is possible to prevent the flow rate of a buffer solution or a sample solution flowing through the first sensing channel 631 from momentarily decreasing through the operation of the pump unit 900, and the flow velocity of the buffer solution or a sample solution can be stably maintained.

The second sensing channel 632 can guide a buffer solution or a sample solution that has passed through the biosensor 400 to the tube 700. As an embodiment, the second sensing channel 632 may be in fluid communication with the outlet port 632a formed at the base frame 210, and may be in fluid communication with the first tube connection port 660 by being formed in the left-right direction. The second sensing channel 632 may be disposed in a straight line with the downstream side of the first sensing channel 631. The channel passing through the biosensor 400 is formed in the form of a straight line, so it is possible to stably maintain the flow velocity and/or flow rate of a buffer solution or a sample solution flowing through the biosensor 400 and it is possible to improve sensing accuracy for bio-substances.

The channel 600 may include a prefill channel 640 that is in fluid communication with the sample solution channel 620 and through which a sample solution flows. A first side of the prefill channel 640 may be in fluid communication with the sample solution channel 620. The first side of the prefill channel 640 may be in fluid communication with the sample solution port 625. A second side of the prefill channel 640 may be in fluid communication with the prefill port 645.

The prefill channel 640 can guide a sample solution, which has passed through the sample solution channel 620, to the prefill port 645. As an embodiment, the prefill channel 640 may be formed in fluid communication with the sample solution channel 620, and may be in fluid communication with the prefill port 645 by bending a plurality of times.

The width of at least a portion of the prefill channel 640 may be changed. As an embodiment, the width of the inlet side and the width of the outlet side of the prefill channel 640 may be the same and a section in which the width decreases may be formed therebetween.

A valve 641 having a width larger than those of the inlet and the outlet may be provided in the prefill channel 640. The valve 641 may have the largest width in the prefill channel 640 and the width of the inlet side for inflow to the valve 641 may be the smallest in the prefill channel 640. Accordingly, when a large amount of sample solution momentarily flows into the prefill channel 640, it is possible to prevent the sample solution from being discharged to the prefill port 645.

The channel 600 may include a waste solution channel 650 that guides a buffer solution or a sample solution, which has passed through the tube 700, to the waste solution tank 330. In detail, a first side of the waste solution channel 650 may be in fluid communication with the second tube connection port 670. A second side of the waste solution channel 650 may be in fluid communication with the waste solution port 655. When the pump unit 900 is operated, a buffer solution or a sample solution that has passed through the tube 700 can be stored in the waste solution tank 330.

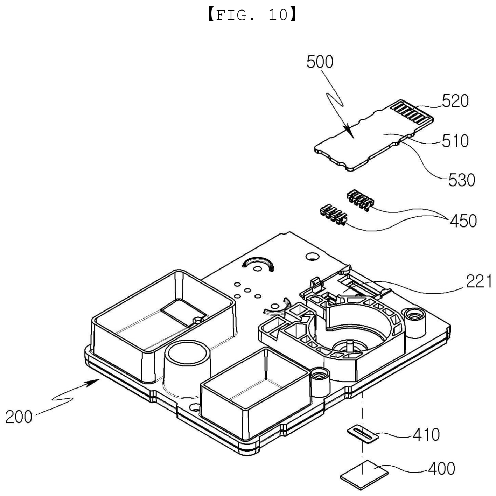

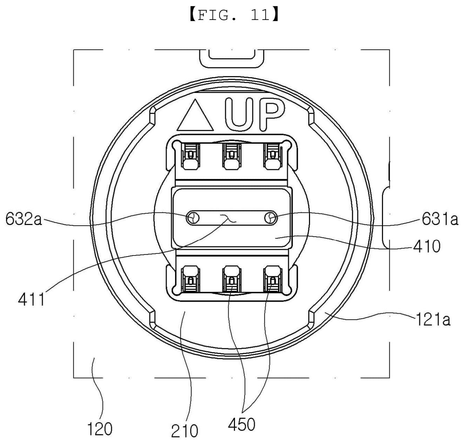

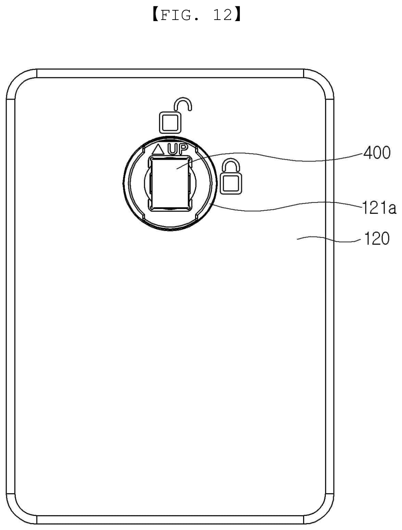

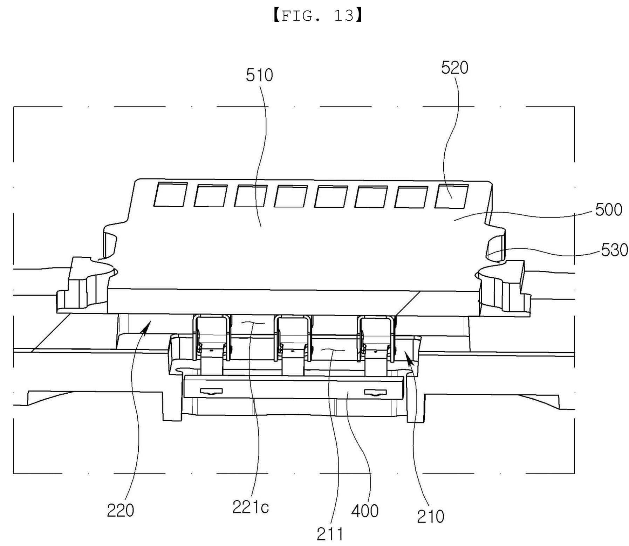

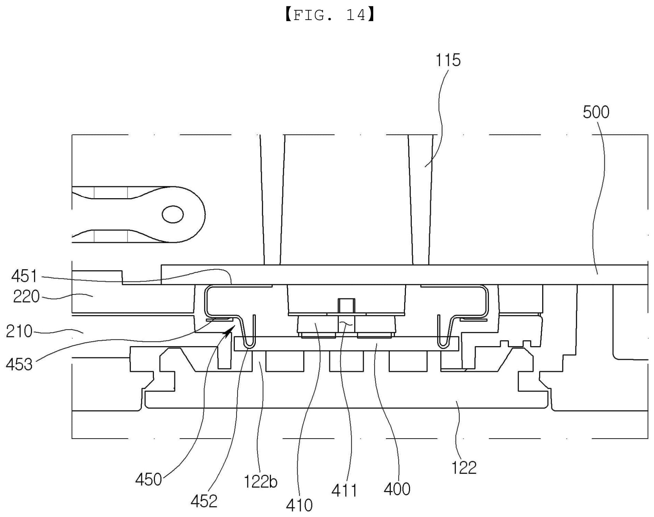

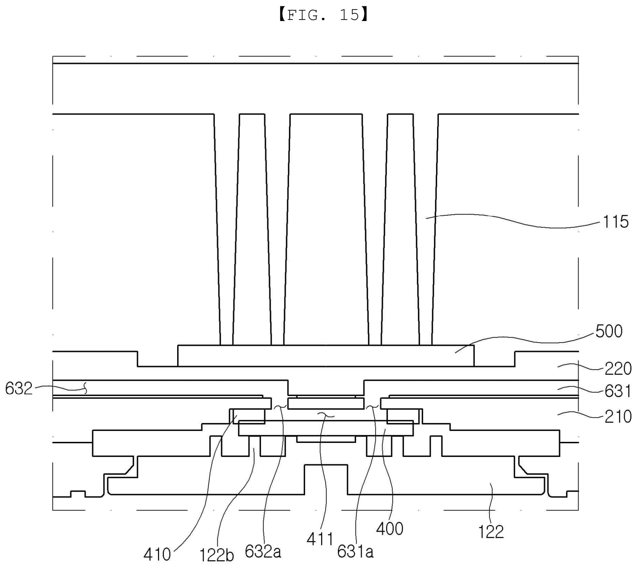

FIG. 10 is a view illustrating combination of a biosensor and a printed circuit board with a frame in the biosensor cartridge according to an embodiment of the present disclosure. FIG. 11 is a view illustrating a sensor coupling portion in the biosensor cartridge according to an embodiment of the present disclosure. FIG. 12 is a view illustrating the state in which the sensor coupling portion has been coupled in the biosensor cartridge according to an embodiment of the present disclosure. FIG. 13 is a cross-sectional view illustrating contact between the biosensor and the printed circuit board in the biosensor cartridge according to an embodiment of the present disclosure. FIG. 14 and FIG. 15 are cross-sectional views illustrating arrangement of the biosensor and the printed circuit board and the arrangement of flow paths on the biosensor in the biosensor cartridge according to an embodiment of the present disclosure.

Referring to FIG. 10 to FIG. 15, the biosensor 400 is detachably coupled to the frame 200 and can sense bio-substances. The biosensor 400 can be introduced through the sensor introduction hole 121 of the lower housing 120 and can be coupled to the sensor coupling portion 211 of the base frame 210.

The biosensor 400 can selectively detect trace amounts of biological substances to be analyzed by converting biological interactions and recognition reactions into electrical signals, with a bio receptor that has a recognition function for specific bio-substances combined with an electrical transducer.

As an embodiment, a sensing unit may be disposed on the top surface of the biosensor 400. A bio receptor may be disposed on the sensing unit. A buffer solution and a sample solution can flow in the sensing unit. A circuit is connected to the sensing unit, so electric signals generated by the sensing unit can be transmitted.

A circuit may be disposed on the biosensor 400 and may be electrically connected with the printed circuit board 500 through the contact clips 450.

A sealer 410 may be disposed on the biosensor 400. The sealer 410 may be disposed at the sensor coupling portion 211. A flow path-forming portion 411 may be formed at the sealer 410. As an embodiment, the sealer 410 may be formed in the form of a rectangular prism, and the flow path-forming portion 411 may be in the form of a slit formed in the left-right direction.

The flow path-forming portion 411 may be disposed under the frame with the sensor coupling portion 211. The flow path-forming portion 411 may be disposed under the inlet port 631a and the outlet port 632a formed at the sensor coupling portion 211 and may be in fluid communication with the inlet port 631a and the outlet port 632a. A buffer solution and a sample solution that have flowed through the first sensing channel 631 can flow into the flow path in the flow path-forming portion 411 through the inlet port 631a and can flow into the second sensing channel 632 through the outlet port 632a.

The flow path-forming portion 411 may be disposed on the sensing portion of the biosensor 400. The sealer 410 may be formed to surround the outer periphery of the sensing portion. The sealer 410 seals the outer periphery of the flow path-forming portion 411, thereby being able to prevent a buffer solution and a sample solution flowing through the inside of the flow path-forming portion 411 from leaking to the outside.

The printed circuit board 500 may be detachably coupled to the frame 200. At least a portion of the biosensor 400 can be inserted into the upper housing 110 and can be detachably coupled to the substrate coupling portion 221 of the top frame 220. The printed circuit board 500 can be supported by the coupling guide portions 221a and the substrate supporting portions 221b.

The printed circuit board 500 may include a substrate body 510, a connector 520, and guide portions 530. As an embodiment, the substrate body 510 may be formed in the form of a substantially rectangular flat plate. A circuit may be mounted on the substrate body 510 and electrically connected with the biosensor 400.

The connector 520 may be disposed at the front end of the substrate body 510. The connector 520 may be connected with the circuit on the substrate body 510. When the biosensor cartridge 1 is coupled to the diagnostic device 2, electric signals can be transmitted to the diagnostic device 2 through the connector 520. When the biosensor cartridge 1 is coupled to the diagnostic device 2, power can be applied to the printed circuit board 500 and the biosensor 400 through the connector 520.

The guide portions 530 may be formed at both left and right ends of the substrate body 510, respectively, and may be coupled with the substrate supporting portions 221b of the substrate coupling portion 221. As an embodiment, the guide portions 530 may be recessed in the form of a curved surface on both left and right ends of the substrate body 510, respectively. Accordingly, it is possible to guide the accurate coupling position of the printed circuit board 500 through engagement with the protruding shape of the substrate supporting portions 221b, and it is possible to stably support the printed circuit board 500 in the state in which the printed circuit board 500 is coupled.

The contact clips 450 may be disposed between the biosensor 400 and the printed circuit board 500. The contact clips 450 are coupled to the substrate coupling portion 221 and can be in contact with the printed circuit board 500 and the biosensor 400. The contact clips 450 may be arranged to extend through the clip accommodation holes 221c, may be arranged to extend through the holes of the sensor coupling portion 211, and at least a portion thereof may be supported on the base frame 210.

The contact clips 450 may be provided as a plurality of contact clips. The contact clips 450 may be provided in an even number. The contact clips 450 may be arranged in a plurality of pairs side by side, with one pair symmetrically arranged at positions facing each other. As an embodiment, six contact clips 450 may be provided, with three pairs arranged side by side, and each pair may be symmetrically arranged at positions facing each other.

The contact clips 450 may be made of a conductive material. As an embodiment, the contact clips 450 may be made of a metal material. The contact clips 450 each may include a substrate contact portion 451, a sensor contact portion 452, and a connecting portion 453.

The substrate contact portion 451 may be arranged to extend through the clip accommodation hole 221c. The substrate contact portion 451 can be in contact with a terminal (not shown) provided at the printed circuit board 500. That is, the substrate contact portion 451 can be electrically connected with the circuit mounted on the printed circuit board 500. As an embodiment, the substrate contact portion 451 may be in the form of a plate extending in the front-rear direction.

The sensor contact portion 452 is arranged to extend through a hole formed at the sensor coupling portion 211 and can be in contact with a terminal (not shown) provided at the biosensor 400. That is, the sensor contact portion 452 can be electrically connected with the circuit mounted on the biosensor 400. As an embodiment, the sensor contact portion 452 may be in the form of a plate extending downward from the connecting portion 453 and then bending and extending upward.

The total height of the contact clip 450 in the vertical direction may be larger than the shortest distance between the biosensor 400 and the printed circuit board 500. Accordingly, when the sensor contact portion 452 comes into contact with the biosensor 400, the sensor contact portion 452 can press the biosensor 400 while elastically deforming, and the contact state can be firmly maintained while the contact area with the biosensor 400 is minimized.

The connecting portion 453 may be formed to connect the substrate contact portion 451 and the sensor contact portion 452. The connecting portion 453 may bend and extend downward from the substrate contact portion 451, then bend and extend in the front-rear direction, and bend and extend downward, whereby it can be connected with the sensor contact portion 452. The connecting portion 453 can be supported in contact with the base frame 210.

When the contact clips 450 are seated on the frame 200, the upper side thereof can be in contact with the printed circuit board and the lower side can be in contact with the biosensor 400. It is possible to transmit electrical signals generated by the biosensor 400 to the printed circuit board through the shortest distance via the contact clips 450 even while allowing a buffer solution and a sample solution to flow between the printed circuit board 500 and the biosensor 400.

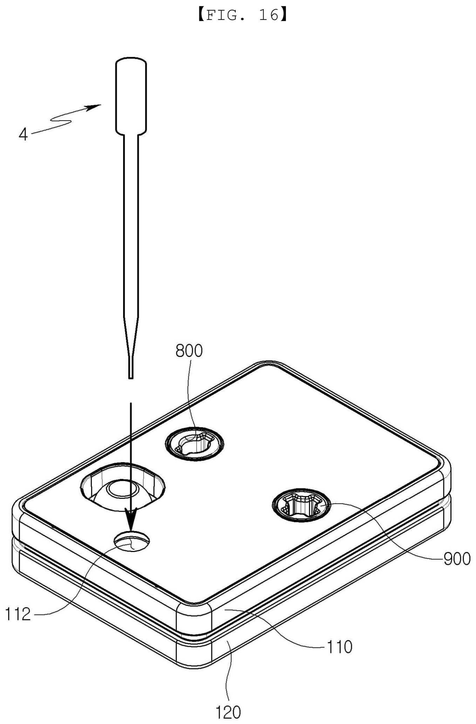

FIG. 16 is a view illustrating a process of diagnosing a sample solution introduced in a biosensor cartridge using a diagnostic device according to an embodiment of the present disclosure.

Referring to FIG. 1, FIG. 2, and FIG. 16, the biosensor 400 and the printed circuit board 500 may have been coupled to the biosensor cartridge 1. However, when there is an error with the biosensor 400 and the printed circuit board 500, a user can replace them.

A user can inject a buffer solution into the biosensor cartridge 1. A user can inject a buffer solution into the buffer solution introduction hole 111. It is possible to inject a buffer solution into the buffer solution introduction hole 111 using a buffer blister 3.

As an embodiment, the buffer blister 3 may have an upper portion formed in a circular dome shape and a lower portion formed in a flat shape. The upper portion of the buffer blister 3 may be deformable material and the lower surface of the buffer blister 3 may be made of a material that can be torn.

The buffer blister 3 may be accommodated in the blister accommodation groove 111a. The buffer blister 3 may not only be fixedly provided in the blister accommodation groove 111a, but may also be detachably coupled to the blister accommodation groove 111a.

A user can put the buffer blister 3 into the blister accommodation groove 111a and then press down the buffer blister 3 using fingers, etc. In this case, the dome-shaped upper portion of the buffer blister 3 is deformed downward, and the bottom surface of the buffer blister 3 bursts while the internal pressure of the buffer blister 3 is increased, and the buffer solution stored in the buffer blister 3 flows down by gravity and can flow into the buffer solution introduction hole 111.

The buffer solution that has passed through the buffer solution introduction hole 111 can be accommodated into the buffer solution tank 310. Further, the buffer solution can flow into the buffer solution inlet port 315 along the inclined surface 311. Further, a portion of the buffer solution accommodated in the buffer solution tank 310 can flow along the buffer solution channel 610. However, without operation of the pump unit 900, the sample solution may be in a state in which it has not flowed to the sensing channel 630.

A user can inject a sample solution into the sample solution introduction hole 112. The user can inject a sample solution into the sample solution introduction hole 112 using a sample injection tool 4, including a dropper.

A buffer solution and a sample solution may be simultaneously injected, a buffer solution may be injected after a sample solution is injected, and a sample solution may be injected after a buffer solution is injected.

The sample solution that has passed through the sample solution introduction hole 112 can be accommodated into the sample solution tank 320. Further, a portion of the sample solution accommodated in the sample solution tank 320 can flow along the sample solution channel 620. However, without operation of the pump unit 900, the sample solution may be in a state in which it has not flowed to the sensing channel 630.

After a buffer solution and a sample solution are injected, a user can insert the biosensor cartridge 1 into the diagnostic device 2.

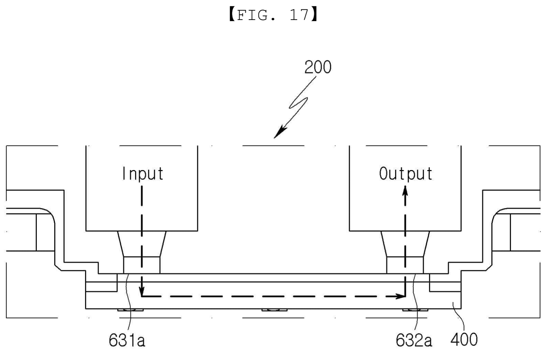

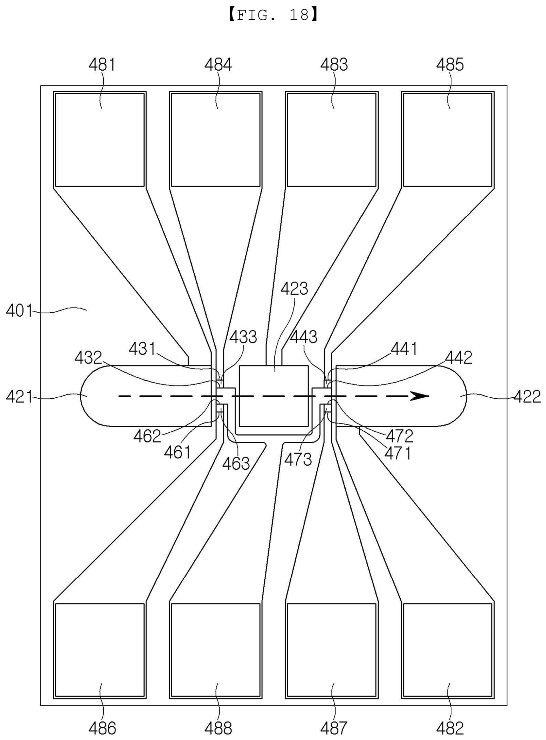

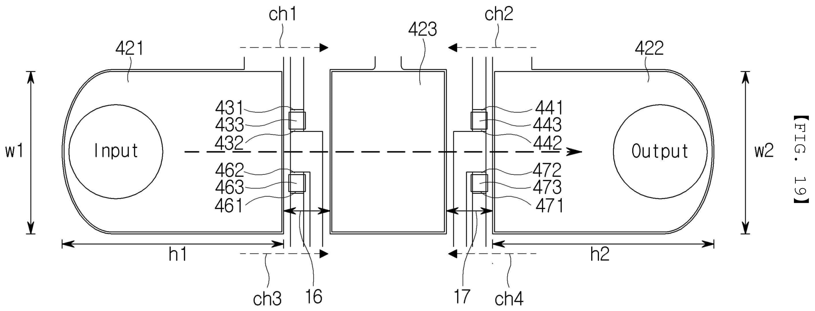

FIG. 17 is a cross-sectional view illustrating a biosensor in which a solution flows in accordance with an embodiment of the present disclosure. FIG. 18 to FIG. 20 are views illustrating circuit arrangement of a biosensor according to an embodiment of the present disclosure.

Referring to FIG. 17 to FIG. 19, the biosensor 400 according to an embodiment of the present disclosure may include a substrate 401, a first gate 421, a second gate 422, a potential measurement unit 423, a first drain 431, a first source 432, a first drain source channel 433, a second drain 441, a second source 442, a second drain source channel 443, a third drain 461, a third source 462, a third drain source channel 463, a fourth drain 471, a fourth source 472, a fourth drain source channel 473, a first gate electrode 481, a second gate electrode 482, a potential measurement unit electrode 483, a first drain electrode 484, a second drain electrode 485, a third drain electrode 486, a fourth drain electrode 487, and a source electrode 488.

The substrate 401, as an embodiment, may be in a single crystal state and may include a silicon (Si) material. The substrate 401, as an embodiment, may be a substrate made thin through a thinning process.

The first gate 421 may be formed on the substrate 401. The first gate 421 may be disposed or formed at the central position on the substrate 401.

The first gate 421 may be disposed or formed under the inlet port 631a formed on the base frame 210 of the biosensor cartridge 1 when it is coupled to the biosensor cartridge 1.

The second gate 422 may be formed on the substrate 401. The second gate 422 may be disposed or formed at the central position on the substrate 401. The second gate 422 may be disposed or formed on the same straight line at a position spaced apart from the first gate 421 by a predetermined distance.

The second gate 422 may be disposed or formed under the outlet port 632a on the base frame 210 of the biosensor cartridge 1 when it is coupled to the biosensor cartridge 1.

The first gate 421 and the second gate 422 may include polysilicon or a metal material (e.g., tungsten (W), copper (Cu), aluminum (Al), gold (Au), and palladium (Pd)).

The first gate 421 and the second gate 422 may be formed through patterning by photolithography and deposition processes, such as CVD.

The potential measurement unit 423 is formed between the first gate 421 and the second gate 422 and can measure the potential of each of the first gate 421 and the second gate 422.

Channel portions 433, 443, 463, and 473 may be formed between the first gate 421 and the potential measurement unit 423 and between the potential measurement unit 423 and the second gate 422.

The first gate 421, the potential measurement unit 423, and the second gate 422 may be formed on the same straight line and may be formed to have a symmetric sandwich structure. Accordingly, a straight electric field is applied to the channel portions 433, 443, 463, and 473 from both the first gate 421 and the second gate 422, so a stable field effect can be generated. Further, by the structure of the first gate 421, the potential measurement unit 423, and the second gate 422, the flexibility in fluid movement direction is increased, so the sensing accuracy can be improved.

A first gap 16 may be formed between the first gate 421 and the potential measurement unit 423, and a second gap 17 may be formed between the potential measurement unit 423 and the second gate 422. As an embodiment, the first gap 16 and the second gap 17 may be the same. Accordingly, it is possible to effectively reduce the differences between the channels.

Since the first gate 421 is disposed under the inlet port 631a formed on the base frame 210 of the biosensor cartridge 1 and the second gate 422 is disposed under the outlet port 632a on the base frame 210 of the biosensor cartridge 1, it is possible to always maintain the potential at a constant level, and accordingly, it is possible to reduce measurement noise and improve the sensing accuracy.

The channel portions may include the first drain source channel 433, the second drain source channel 443, the third drain source channel 463, and the fourth drain source channel 473.

The first drain source channel 433 is formed at the first drain 431 and the first source 432 and may be formed between the first gate 421 and the potential measurement unit 423.

The second drain source channel 443 is formed at the second drain 441 and the first source 442 and may be formed between the potential measurement unit 423 and the second gate 422.

The third drain source channel 463 is formed at the third drain 461 and the third source 462 and may be formed between the first gate 421 and the potential measurement unit 423.

The fourth drain source channel 473 is formed at the fourth drain 471 and the fourth source 472 and may be formed between the potential measurement unit 423 and the second gate 422.

The first drain source channel 433, the second drain source channel 443, the third drain source channel 463, and the fourth drain source channel 473, as an embodiment, may include graphene. The first drain source channel 433, the second drain source channel 443, the third drain source channel 463, and the fourth drain source channel 473, as an embodiment, may formed through patterning or a graphene deposition process.

The first drain 431 may be formed at one side of the first drain source channel 433 and the first source 432 may be formed at another side of the first drain source channel 433.

The second drain 441 may be formed at one side of the second drain source channel 443 and the second source 442 may be formed at another side of the second drain source channel 443.

The third drain 461 may be formed at one side of the third drain source channel 463 and the third source 462 may be formed at another side of the third drain source channel 463.

The fourth drain 471 may be formed at one side of the fourth drain source channel 473 and the fourth source 472 may be formed at another side of the fourth drain source channel 473.

The first drain 431, the second drain 441, the third drain 461, the fourth drain 471, the first source 432, the second source 442, the third source 462, and the fourth source 472, as an embodiment, may include polysilicon or a metal material (e.g., tungsten (W), copper (Cu), aluminum (Al), gold (Au), and palladium (Pd)).

The first drain 431, the second drain 441, the third drain 461, the fourth drain 471, the first source 432, the second source 442, the third source 462, and the fourth source 472, as an embodiment, may be formed by patterning through a photolithography process and deposition processes such as CVD.

The first gate electrode 481 is formed at one corner of the substrate 401 and can be electrically connected to the first gate 421. The first gate electrode 481 can be electrically connected to the contact clips 450 of the biosensor cartridge 1 when it is coupled to the biosensor cartridge 1.

The second gate electrode 482 is formed at another corner of the substrate 401 and can be electrically connected to the second gate 422. The second gate electrode 482 can be electrically connected to the contact clips 450 of the biosensor cartridge 1 when it is coupled to the biosensor cartridge 1.

The potential measurement unit electrode 483 is formed on the substrate 401 at a position spaced apart from the first gate electrode 481 by a predetermined distance, and can be electrically connected to the potential measurement unit 423. The potential measurement unit 423 can be electrically connected to the contact clips 450 of the biosensor cartridge1 when it is coupled to the biosensor cartridge 1.

The first drain electrode 484 is formed on the substrate 401, between the first gate electrode 481 and the potential measurement unit 423, and can be electrically connected to the first drain 431. The first drain electrode 484 can be electrically connected to the contact clips 450 of the biosensor cartridge 1 when it is coupled to the biosensor cartridge 1.

The second drain electrode 485 is formed on the substrate 401 at a position spaced apart from the potential measurement unit electrode 483 by a predetermined distance, and can be electrically connected to the second drain 441. The second drain electrode 485 can be electrically connected to the contact clips 450 of the biosensor cartridge 1 when it is coupled to the biosensor cartridge 1.

The third drain electrode 486 is formed at the corner opposite to the first gate electrode 481 or the second gate electrode 482 on the substrate 401, and can be electrically connected to the third drain 461. The third drain electrode 486 can be electrically connected to the contact clips 450 of the biosensor cartridge 1 when it is coupled to the biosensor cartridge 1.

The fourth drain electrode 487 is formed on the substrate 401 at a position spaced apart from the second gate electrode 482 by a predetermined distance, and can be electrically connected to the fourth drain 471. The fourth drain electrode 487 can be electrically connected to the contact clips 450 of the biosensor cartridge 1 when it is coupled to the biosensor cartridge 1.

The source electrode 488 is formed between the third drain electrode 486 and the fourth drain electrode 487, and can be electrically connected to the first source 432, the second source 442, the third source 462, and the fourth source 472. The source electrode 488 can be electrically connected to the contact clips 450 of the biosensor cartridge1 when it is coupled to the biosensor cartridge 1.

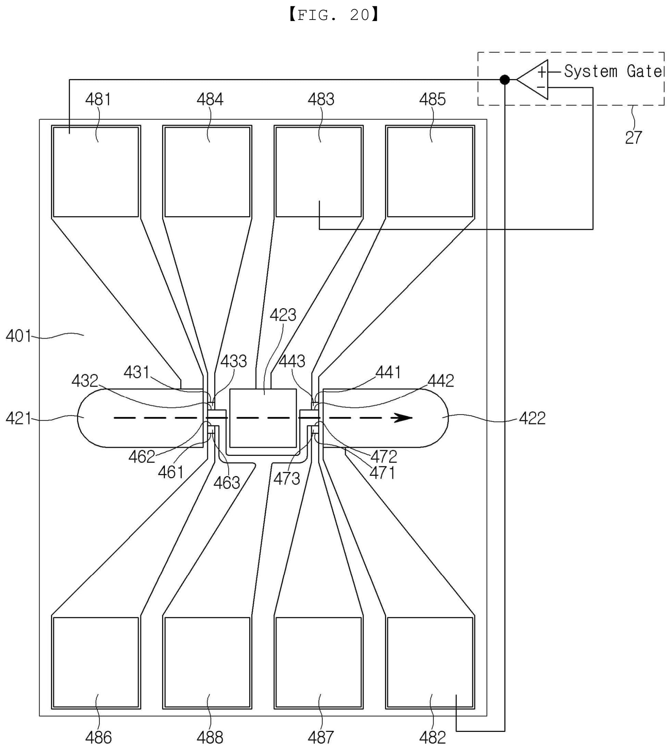

Referring to FIG. 20, as an embodiment, the biosensor 400 may further include a potential compensator 27.

One end of the potential compensator 27 may be electrically connected to the first gate electrode 481 and the second gate electrode 482, and another end of the potential compensator 27 may be electrically connected to the potential measurement unit electrode 483.

The potential compensator 27 may include a feedback circuit (Negative Feedback) including a first input terminal (+), a second input terminal (-), and an output terminal. The first input terminal (+) of the potential compensator 27 may be electrically connected to a power source, the second input terminal (-) of the potential compensator 27 may be electrically connected to the potential measurement unit electrode 483, and the output terminal of the potential compensator 27 may be electrically connected to the first gate electrode 481 and the second gate electrode 482.

The potential applied to the first gate 421 and the second gate 422 may pass through the channel portions via fluid and be fed back through the potential measurement unit 423.

It is possible to always maintain the potential of the first gate 421 and the second gate 422, which is applied to the channel portions 433, 443, 463, and 473 through the potential compensator 27, at a constant level, so it is possible to reduce measurement noise and improve the sensing accuracy.

In the present disclosure, the potential compensator 27 may be included in the biosensor, but the present disclosure is not limited thereto, and the potential compensator 27 may be included in the printed circuit board of the biosensor cartridge 1 or the diagnostic device 2.

Through not shown in a separate figure, the biosensor 400 according to an embodiment of the present disclosure may include a substrate, a gate, a potential measurement unit, a first drain, a first source, a first drain source channel, a second drain, a second source, a second drain source channel, a gate electrode, a potential measurement unit electrode, a first drain electrode, a second drain electrode, and a source electrode. In FIG. 20, the potential measurement unit is formed on the substrate at a position spaced apart by a predetermined distance and can measure potential of the gate.

The channel portions may be formed between the gate and the potential measurement unit and may include the first drain source channel and the second drain source channel.

The first drain source channel may be formed between the gate and the potential measurement unit, and the second drain source channel may be formed between the gate and the potential measurement unit at a position spaced apart from the first drain source by a predetermined distance.

The gate and the potential measurement unit may be formed on the same straight line.

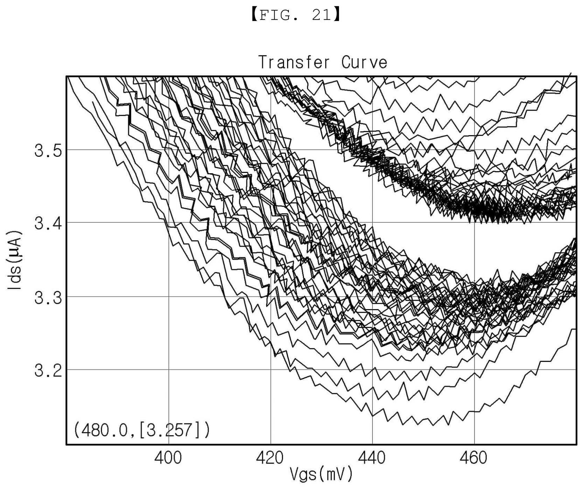

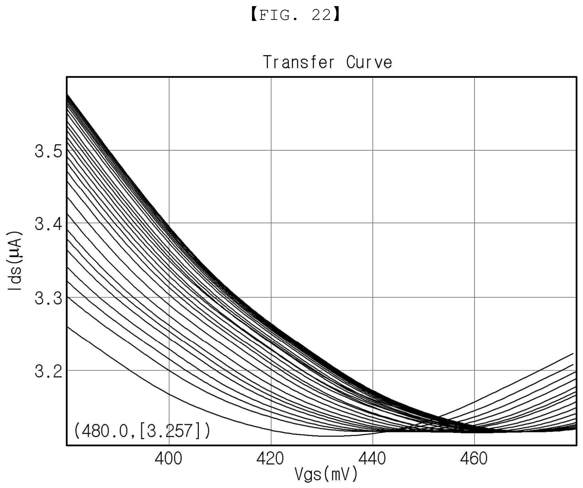

FIG. 21 and FIG. 22 are views illustrating reduction of transfer curve noise according to an embodiment of the present disclosure.

FIG. 21 is a view showing transfer curves representing the relationship between a drain current I_ds and a gate voltage V_gs of a biosensor of the related art, and FIG. 22 is a view showing transfer curves of the biosensor according to the present disclosure.

Referring to FIG. 21 and FIG. 22, according to the present disclosure, there is an effect of significantly reducing transfer curve noise compared to the biosensor of the related art.

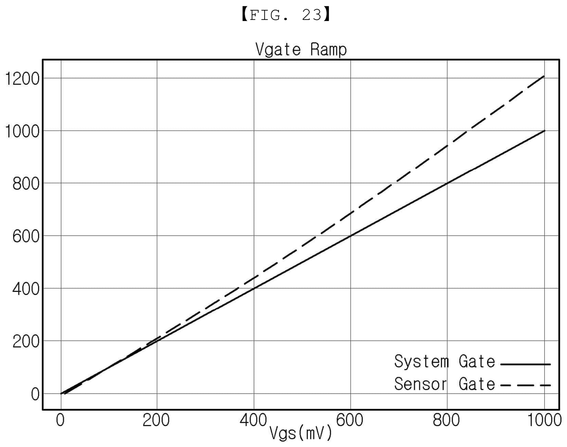

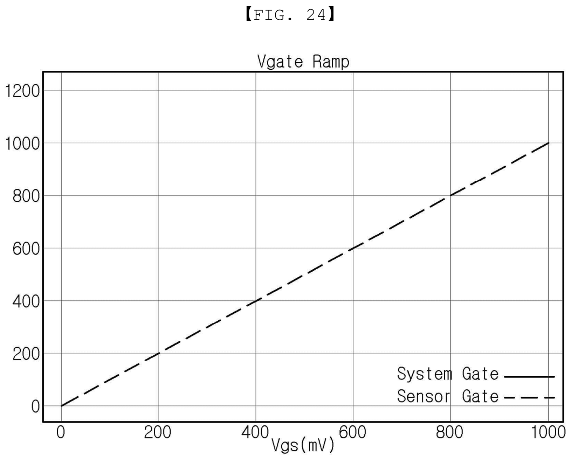

FIG. 23 and FIG. 24 are views illustrating potential compensation according to an embodiment of the present disclosure.

FIG. 23 is a view showing the gate potential of a biosensor of the related art and FIG. 24 is a view showing the gate potential of the biosensor according to the present disclosure.

Referring to FIG. 23 and FIG. 24, the present disclosure, compared to the biosensor of the related art, allows the gate potential to be constantly maintained without the drop in the system gate potential and the voltage drop between gates by gate potential compensation, thereby being able to reduce measurement noise and improve the sensing accuracy.

Although the present disclosure was described in detail with reference to detailed embodiments, the embodiments are provided only to describe the present disclosure in detail and the present disclosure is not limited to the embodiments. Further, it is apparent that the present disclosure may be changed and improved by those skilled in the art without departing from the spirit of the present disclosure.

Simple changes and modifications of the present disclosure are included in the range of the present disclosure and the detailed protection range of the present disclosure will be made clear by the accompanying claims.

## Claims

1. A biosensor comprising:
a substrate (401);
a first gate (421) formed on the substrate (401);
a second gate formed on the substrate; and
a potential measurement unit (423) formed between the first gate (421) and the second gate (422) and configured to measure a potential of the first gate (421) and a potential of the second gate (422),
**characterized in that**, channel portions are formed between the first gate (421) and the potential measurement unit (423) and between the potential measurement unit (423) and the second gate (422).

2. The biosensor of claim 1, wherein the channel portions comprise:
a first drain-source channel (433) formed between the first gate (421) and the potential measurement unit (423);
a second drain-source channel (443) formed between the potential measurement unit (423) and the second gate (422);
a third drain-source channel (463) formed between the first gate (421) and the potential measurement unit (423) at a position spaced apart from the first drain-source channel (433) by a predetermined distance; and
a fourth drain-source channel (473) formed between the potential measurement unit (423) and the second gate (422) at a position spaced apart from the second drain-source channel (443) by a predetermined distance.

3. The biosensor according to claim 1 or 2, wherein the first gate (421), the potential measurement unit (423) and the second gate (422) are formed on a same straight line.

4. The biosensor according to any one of claims 1 to 3, wherein a first gap is formed between the first gate (421) and the potential measurement unit (423),
a second gap is formed between the potential measurement unit (423) and the second gate (422),
and the first gap and the second gap are equal.

5. The biosensor according to any one of claims 1 to 4, further comprising:
a first drain(431) formed at one side of the first drain source channel;
a first source(432) formed at another side of the first drain source channel;
a second drain(441) formed at one side of the second drain source channel;
a second source (442) formed at another side of the second drain source channel;
a third drain(461) formed at one side of the third drain source channel;
a third source(462) formed at another side of the third drain source channel;
a fourth drain(471) formed at one side of the fourth drain source channel; and
a fourth source(472) formed at another side of the fourth drain source channel.

6. The biosensor of claim 1, further comprising:
a first gate electrode(481) connected to the first gate(421);
a second gate electrode(482) connected to the second gate(422); and
a potential measurement unit electrode(483) connected to the potential measurement unit(423),
wherein the first gate electrode(481) and the second gate electrode(482) are electrically connected to one end of a potential compensator configured to compensate the potential of the first gate and the potential of the second gate to a predetermined potential, and
the potential measurement unit electrode(483) is electrically connected to another end of the potential compensator.

7. The biosensor of claim 1,
wherein the biosensor comprises only one gate, such that the first gate (421) or the second gate (422) is omitted, and the potential measurement unit (423) is spaced apart from the remaining gate by a predetermined distance, and
wherein a channel portion is formed between the gate and the potential measurement unit(423).

8. The biosensor of claim 7, wherein the channel portion comprises:
a first drain source channel formed between the gate and the potential measurement unit(423); and
a second drain source channel formed between the gate and the potential measurement unit(423) at a position spaced apart from the first drain source channel by a predetermined distance.

9. The biosensor of claim 7, wherein the gate and the potential measurement unit(423) are formed on the same straight line.

10. A sensing system comprising:
a biosensor cartridge(1) having a flow path(600) through which a solution flows;
a biosensor(400) disposed in the biosensor cartridge(1); and
a diagnostic device(2) configured to analyze signals received from the biosensor (400),
wherein the biosensor comprises:
a substrate (401);
a first gate(421) formed on the substrate(401);
a second gate(422) formed on the substrate(401); and
a potential measurement unit(423) formed between the first gate(421) and the second gate(422) and configured to measure potential of the first gate(421) and potential of the second gate(422), and
**characterized in that** channel portions are formed between the first gate(421) and the potential measurement unit(423) and between the potential measurement unit(423) and the second gate(422).

11. The sensing system of claim 10, wherein the channel portions comprise:
a first drain source channel(433) formed between the first gate(421) and the potential measurement unit(423);
a second drain source channel(443) formed between the potential measurement unit(423) and the second gate(422);
a third drain source channel(463) formed between the first gate(421) and the potential measurement unit (423) at a position spaced apart from the first drain source channel(433) by a predetermined distance; and
a fourth drain source channel(473) formed between the potential measurement unit(423) and the second gate(422) at a position spaced apart from the second drain source channel(443) by a predetermined distance.

12. The sensing system of claim 10, wherein the first gate(421), the potential measurement unit(423), and the second gate(422) are formed in the same straight-line direction as a flow direction of the solution.

13. The sensing system of claim 10, wherein a first gap is formed between the first gate(421) and the potential measurement unit(423),
a second gap is formed between the potential measurement unit(423) and the second gate(422), and
the first gap and the second gap are the same.

14. The sensing system of claim 10, wherein the diagnostic device(2) comprises a potential compensator configured to compensate potential in order to maintain potential of the first gate(421) and potential of the second gate(422) at a predetermined potential.

15. The sensing system of claim 14, wherein the biosensor(400) further comprises:
a first gate electrode(481) connected to the first gate(421);
a second gate electrode(482) connected to the second gate(422); and
a potential measurement unit electrode(483) connected to the potential measurement unit(423),
wherein the first gate electrode(481) and the second gate electrode(482) are electrically connected to one end of the potential compensator, and
the potential measurement unit electrode(483) is electrically connected to another end of the potential compensator.
